# EUROPÄISCHE PATENTANMELDUNG

(11) **EP 0 563 668 A2**
(43) Veröffentlichungstag der Anmeldung: **06.10.1993**
(21) Anmeldenummer: 93104162.8
(22) Anmeldetag: 15.03.1993
(51) Int. Cl.: H01L 23/473, H01L 23/433

(54) **Einrichtung zum Kühlen von zu Flachbaugruppen zusammengefassten gehäuselosen integrierten Bausteinen**

(30) Priorität: 01.04.1992 DE 4210836
(71) Anmelder: Siemens Nixdorf Informationssysteme Aktiengesellschaft, D-33102 Paderborn (DE)
(72) Erfinder: Bachl, Johann, Dipl.-Ing., W-8000 München (DE)
(74) Vertreter: Fuchs, Franz-Josef, Dr.-Ing.

(57) **Zusammenfassung**

Die Erfindung bezieht sich auf eine Einrichtung zum Kühlen von zu Flachbaugruppen zusammengefaßten gehäuselosen filmmontierten integrierten Bausteinen. Die Spider derartiger Bausteine wurden bisher Z-artig gebogen. Dafür ist aber wegen der geforderten Toleranzen ein hoher Arbeitsaufwand erforderlich. Die Erfindung sieht nun vor, diesen Arbeitsaufwand dadurch zu verringern, daß der die Außenanschlüsse (5) bildende Spider flach ausgebildet ist. Die Druckstücke können entweder aus einer elastischen Folie (2) oder aus einer Blattfeder bestehen. Bei der ersten Ausführung wird außerdem flüssiges Kühlmittel unmittelbar an die Bausteinrücken dadurch herangeführt, daß am Bausteinrücken ein Plättchen (1) liegt, welches über eine ringförmige Membran (4) mit der Kühlplatte (6) verbunden ist. Durch Anbohren der Kühlkanäle (9) in der Kühlplatte (6) gelangt das Kühlmittel unmittelbar in den so zwischen Plättchen (1) und Kühlplatte (6) entstehenden Hohlraum.

## Beschreibung

Die Erfindung betrifft eine Einrichtung zum Kühlen von zu Flachbaugruppen zusammengefaßten gehäuselosen filmmontierten integrierten Bausteinen (Mikropacks), deren Außenanschlüsse (Duterleads) mit den zugehörigen Lötflecken (Pads) einer Leiterplatte verbunden sind, wobei die Rückenflächen mit einer allen Bausteinen gemeinsamen ebenen mit Kühlkanälen zur Aufnahme eines Kühlmediums versehenen Kühlplatte kontaktiert sind und zwischen Leiterplatte und integrierten Bausteinen federnde Druckstücke eingefügt sind.

Aus der europäischen Patentschrift 0 103 068 B1 ist eine Einrichtung zum Kühlen einer Mehrzahl von zu Flachbaugruppen zusammengefaßten integrierten Bausteinen bekannt, bei der die hochintegrierten Bausteine über einen Z-förmigen Spider mit der Leiterplatte verbunden sind. Dabei wird der Bauteilekörper auf den Spider aufgelötet (Innerleadbonding) und dann wird der Spider freigeschnitten und Z-förmig gebogen. Der so entstandene Mikropack wird mit den Außenanschlüssen (Outerleads) auf die Leiterplatte aufgelötet. Zwischen Baustein und Leiterplatte sitzen Druckstücke, die Toleranzunterschiede ausgleichen und den Andruck des Bausteins an die Kühlplatte gewährleisten, um die Verlustleistung abzuführen. Der Spider muß Wegunterschiede in Z-Richtung ausgleichen, die durch Zusammendrücken des Druckstückes und durch die Biegung der Leiterplatte entstehen. Dies kann zu höheren Ungenauigkeiten am Spider führen.

Aufgabe der vorliegenden Erfindung ist es, eine Einrichtung zum Kühlen von zu Flachbaugruppen zusammengefaßten integrierten Bausteinen zu schaffen, die eine vereinfachte Herstellung von Mikropacks sowie eine vereinfachte Montage derselben auf Leiterplatte ermöglicht.

Zur Lösung dieser Aufgabe wird die Einrichtung zum Kühlen von zu Flachbaugruppen zusammengefaßten gehäuselosen Bausteinen derart ausgebildet, daß der die Außenanschlüsse bildende Spider des Mikropacks flach ausgebildet ist, daß die Druckstücke aus einer elastischen Folie bestehen, daß zwischen den Rücken der Bausteine und der Kühlplatte ein Kühlplättchen eingefügt ist, das über eine ringförmige Membran an der Kühlplatte befestigt ist, so daß zwischen Kühlplattenoberfläche und Kühlplättchen ein Hohlraum entsteht, daß von den Kühlkanälen der Kühlplatte zu der mit den Bausteinrücken kontaktierten Oberfläche der Kühlplatte Bohrungen vorgesehen sind, so daß das Kühlmittel der Kühlkanäle der Kühlplatte auch in den Hohlraum zwischen Kühlplattenoberfläche und Kühlplättchen fließt.

Diese Folie kann zum Zwecke der Wärmeableitung nach unten auch wärmeleitend ausgebildet sein.

Eine weitere Ausgestaltung der Erfindung sieht vor, daß das Zwischenstück eine wellenförmig ausgebildete Blattfeder ist, die so bemessen ist, daß die Kontakthöcker für die Innenanschlüsse (Innerleads) des Bausteins die Leiterplatte nicht berühren.

Durch diese Maßnahmen werden die durch den Biegevorgang des Spiders bei herkömmlichen Mikropacks häufig auftretenden Ungenauigkeiten zwischen der Deckungsgleichheit seiner Außenanschlüsse mit den jeweils zugeordneten Pads der Leiterplatte, die nur durch aufwendige zusätzliche Maßnahmen verhindert werden können, vermieden.

In vorteilhafter Weise kann die Blattfeder teilweise gestanzt und teilweise geprägt sein, um die Federkraft möglichst gleichmäßig auf den Baustein zu verteilen.

Zwischen Bauteilrücken und Kühlplatte kann eine Metallzwischenlage angeordnet sein, die als Höhenausgleich dient, wenn die benachbarten kleineren Bausteine mit üblichen Druckstücken montiert werden. Eine andere Möglichkeit besteht darin, daß die Kühlplatte an ihrer Unterseite zwei parallel verlaufende ringförmige Nuten enthält und daß die Membranenden über Isolationsmaterial durch Umbiegen des Zwischenstegs zwischen den beiden Nuten festgeklemmt werden.

Zum Temperaturausgleich zwischen Kühlplatte und Baustein können die Außenanschlüsse des Bausteins entweder mit einer Sicke in Z-Richtung versehen sein, oder mit Auslenkungen in der XY-Ebene.

Im Ausführungsbeispiel nach den Figuren 1 bis 5 wird die Erfindung näher erläutert.

Es zeigen
Figur 1 eine erste Einrichtung zum Kühlen von auf Leiterplatten befestigten integrierten Bausteinen,
Figur 2 ein Detail der Figur 1,
Figur 3 eine zweite Einrichtung zum Kühlen von gehäuselosen integrierten Bausteinen auf Leiterplatten,
Figur 4 die Ansichten IV, V aus Figur 3 und
Figur 5 eine Draufsicht auf den Detailbereich IV, V der Figur 3.

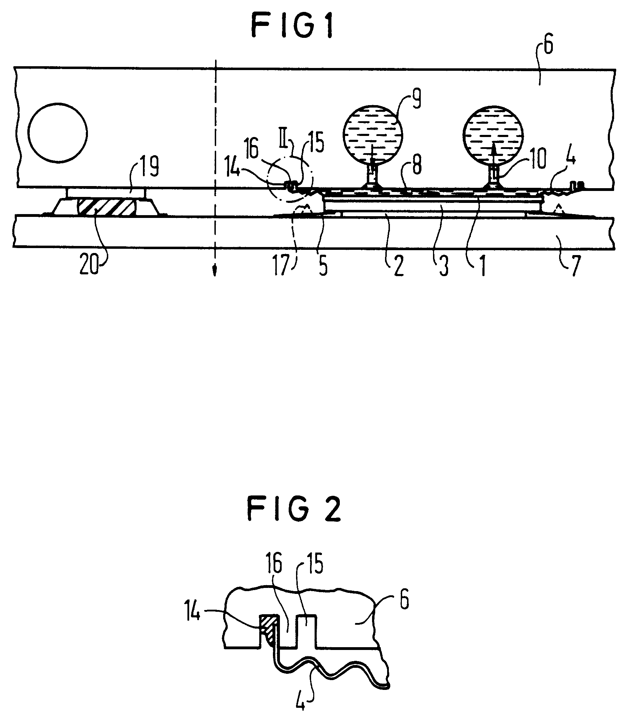

Der als Mikropack ausgeführte LSI-Baustein 3 mit flachem Spider 5 (Figur 1), wird auf eine elastische Folie 2, die isolierend wirkt und Leiterplattenunebenheiten der Leiterplatte 7 ausgleicht, bei der Outerleadmontage aufgesetzt und die Außenanschlüsse mit den Pads der Leiterplatte 7 verlötet. Die ringförmige Membran 4 ist sowohl mit dem rechteckigen Kühlplättchen 1 als auch mit der an der Rückseite der Bausteine 3 anliegenden Kühlplatte 6 vorzugsweise durch Weichlöten verbunden. Die Membrane 4 und das Kühlplättchen 1 können z.B. aus Kupferlegierungen oder bei höheren Korrosionsanforderungen aus Nickelbasislegierungen gefertigt werden. Ist Weichlöten mit der Kühlplatte 6 wegen ungünstier Materialkombinationen, z.B. einer Aluminiumlegierung nicht möglich, so kann die Membran 4, wie in Figur 2 gezeigt, in der ersten Nut 14 vorzugsweise in Isoliermaterial eingebettet, durch plastisches Verformen der zwischen den Nuten 14 und 15 liegenden Nase 16 eingeklemmt werden.

Die wasserdurchflossenen Kühlkanäle 9 der Kühlplatte 6 sind schräg angebohrt, um den Wasserdurchfluß durch die Membrane 4 zu begünstigen und somit optimal Verlustleistung von dem Baustein 3 abzuführen.

Die Höhenunterschiede, die durch Durchbiegungen der Leiterplatte 7 und Toleranzen entstehen, werden durch die federnde Membran 2 ausgeglichen. Der Andruck des Kühlplättchens 1 an den Baustein 3 kann durch die Federkonstante der Membran 4 und durch Regeln des Kühlwasserdruckes gesteuert werden.

Die Membran 4 wird vorzugsweise in einem Prägewerkzeug hergestellt, wobei die physikalischen Eigenschaften den von Kupfer-Nickellegierung ähnlich sein sollen. Die Materialdicke wird je nach Richtzahl und Federkonstante bestimmt. Die Leiterplatte kann gemischt mit LSI- und MSI-Bausteinen (19) bestückt sein.

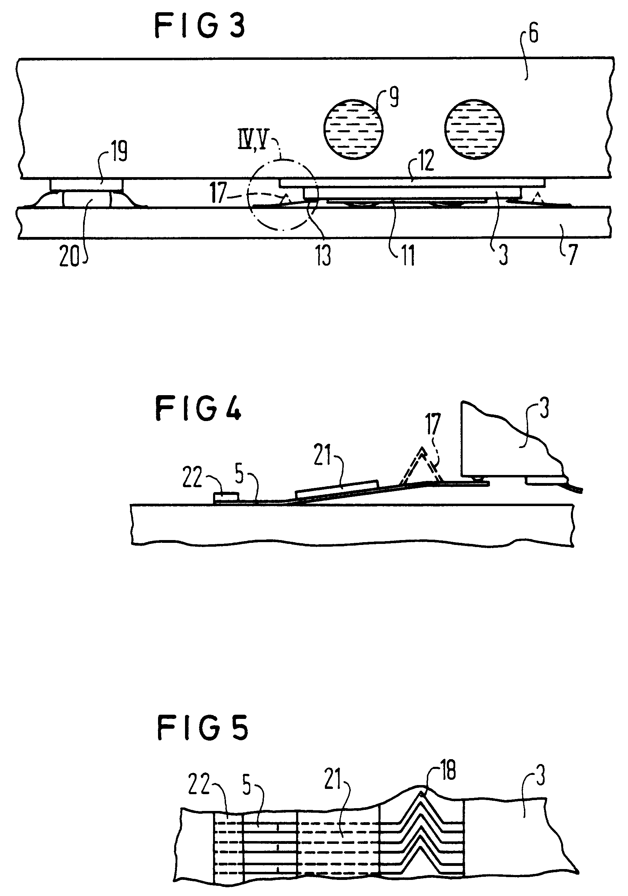

Eine andere Möglichkeit der Kühlung von derartigen Mikropackbausteinen zeigt die Figur 3. Der Baustein 3 wiederum mit flachem Spider 5 wird auf die Leiterplatte montiert und durch die Blattfeder 11 wird der Baustein 3 gegen die Kühlplatte 6 gedrückt. Die Metallzwischenlage 12, vorzugsweise aus Kupfer, dient als Höhenausgleich, wenn die benachbarten kleineren Bausteine, wie z.B. MSI's und RAM's mit elastischen Druckstücken 20 montiert werden.

Die Blattfeder 11 ist wellenförmig geprägt und kann auch teilweise gestanzt und geprägt sein, um die Federkraft möglichst gleichmäßig auf den Baustein zu verteilen. Die Federkonstante kann durch Blechdicke und Prägeform gesteuert weden. Die maximale Höhe der Feder sollte so hoch sein, daß der Spider 5 weitgehend flach bleibt. Die Höhenunterschiede zwischen der Leiterplatte 7 und der Kühlplatte 6, die durch Toleranzen und Leiterplattendurchbiegungen entstehen, werden durch den Federweg der Blattfeder 11 ausgeglichen. Die Blattfeder soll so aufgebaut sein, daß die Innerleadkontakthöcker nicht auf die Leiterplatte 7 stoßen. Außerdem ist zwischen Baustein 3 und Blattfeder 11 eine Isolierschicht vorgesehen.

Vorzugsweise sollte die Blattfeder 8 aus BI-Metall hergestellt werden, damit der Bausteinandruck bei Erwärmung erhöht wird.

Wesentlich für beide beschriebenen Ausführungsformen ist, daß beim Bauelement weitgehend von einem flachen Spider ausgegangen wird. Ein flacher Spider ist toleranzmäßig leichter zu beherrschen und kann leichter montiert werden. So sind z.B. versetzte Pads möglich und er ist auch schneller und billiger herzustellen. Um die unterschiedlichen Ausdehnungen der Leiterplatte 7 und des Bausteins 3 zu kompensieren, wird entweder wie in Figur 4 gezeigt, die Sicke 17 in Z-Richtung eingeprägt, oder eine Auslenkung 18, wie in Figur 5 dargestellt, in der XY-Ebene vorgesehen. Die Streifen 21, 22, der als Rest der Trägerfolie für den Spider 5 auf den Außenanschlüssen erhalten bleiben, sichern konstanten Außenanschlußabstand und können an der Spiderunterseite angebracht werden, wenn Kurzschlußgefahr zur Leiterplatte 7 besteht. Von weiterem Vorteil sind zwei derartige Streifen z.B. beidseits des Wärmeausdehnungsausgleichs. Kleinere Bausteine 19 (MSI's) können wie bisher mit ihren Druckstücken 20 montiert werden.

## Patentansprüche

1. Einrichtung zum Kühlen von zu Flachbaugruppen zusammengefaßten gehäuselosen filmmontierten integrierten Bausteinen (Mikropacks), deren Außenanschlüsse (Outerleads) mit den zugehörigen Lötflecken (Pads) einer Leiterplatte verbunden sind, wobei die Rückenflächen mit einer allen Bausteinen gemeinsamen ebenen mit Kühlkanälen zur Aufnahme eines Kühlmediums versehenen Kühlplatte kontaktiert sind und zwischen Leiterplatte und integrierten Bausteinen federnde Druckstücke eingefügt sind, **dadurch gekennzeichnet,** daß der die Außenanschlüsse (5) bildende Spider des Mikropacks flach ausgebildet ist, daß die Druckstücke aus einer elastischen Folie (2) bestehen, daß zwischen den Rücken der Bausteine (3) und der Kühlplatte (6) ein Kühlplättchen (1) eingefügt ist, das über eine ringförmige Membran (4) an der Kühlplatte (6) befestigt ist, so daß zwischen Kühlplattenoberfläche und Kühlplättchen (1) ein Hohlraum (8) entsteht, daß von den Kühlkanälen (9) der Kühlplatte (6) zu der mit den Bausteinrücken kontaktierten Oberfläche der Kühlplatte (6) Bohrungen (10) vorgesehen sind, so daß das Kühlmittel der Kühlkanäle (9) der Kühlplatte (6) auch in den Hohlraum (8) zwischen Kühlplattenoberfläche und Kühlplättchen (1) fließt.

2. Einrichtung zum Kühlen von zu Flachbaugruppen zusammengefaßten gehäuselosen filmmontierten integrierten Bausteinen (Mikropacks), deren Außenanschlüsse (Outerleads) mit den zugehörigen Lötflecken (Pads) einer Leiterplatte verbunden sind, wobei die Rückenflächen mit einer allen Bausteinen gemeinsamen ebenen mit Kühlkanälen zur Aufnahme eines Kühlmediums versehenen Kühlplatte kontaktiert sind und zwischen Leiterplatte und integrierten Bausteinen federnde Druckstücke eingefügt sind, **dadurch gekennzeichnet,** daß das Zwischenstück eine wellenförmig ausgebildete Blattfeder (11) ist, die so bemessen ist, daß die Kontakthöcker (12) für die Innenanschlüsse (Innerleads) des Bausteins die Leiterplatte (7) nicht berühren.

3. Einrichtung zum Kühlen von zu Flachbaugruppen zusammengefaßten gehäuselosen filmmontierten integrierten Bausteinen (Mikropacks) nach Anspruch 2, **dadurch gekennzeichnet,** daß die Blattfeder (8) teilweise gestanzt und teilweise geprägt ist.

4. Einrichtung zum Kühlen von zu Flachbaugruppen zusammengefaßten gehäuselosen filmmontierten integrierten Bausteinen (Mikropacks) nach einem der Ansprüche 2 oder 3, **dadurch gekennzeichnet,** daß zwischen Bauteilerücken und Kühlplatte (6) eine Metallzwischenlage (12) angeordnet ist.

5. Einrichtung zum Kühlen von zu Flachbaugruppen zusammengefaßten gehäuselosen filmmontierten integrierten Bausteinen (Mikropacks) nach Anspruch 1, **dadurch gekennzeichnet,** daß die Verbindung zwischen Kühlplatte (6) und Kühlplättchen (1) mittels Weichlot erfolgt.

6. Einrichtung zum Kühlen von zu Flachbaugruppen zusammengefaßten gehäuselosen filmmontierten integrierten Bausteinen (Mikropacks) nach Anspruch 1, **dadurch gekennzeichnet,** daß die Kühlplatte (6) an ihrer Unterseite zwei parallellaufende ringförmige Nuten (14,15) enthält und daß die Membranenden über Isolationsmaterial durch Umbiegen des Zwischenstegs (16) zwischen den beiden Nuten (15) festgeklemmt wird.

7. Einrichtung zum Kühlen von zu Flachbaugruppen zusammengefaßten gehäuselosen filmmontierten integrierten Bausteinen (Mikropacks) nach einem der vorhergehenden Ansprüche, **dadurch gekennzeichnet,** daß die Außenanschlüsse (5) mit einer Sicke versehen sind.

8. Einrichtung zum Kühlen von zu Flachbaugruppen zusammengefaßten gehäuselosen filmmontierten integrierten Bausteinen (Mikropacks) nach einem der Ansprüche 1 bis 6, **dadurch gekennzeichnet,** daß die Außenanschlüsse (5) in der Montageebene befindliche Auslenkungen (15) aufweisen.

9. Einrichtung zum Kühlen von zu Flachbaugruppen zusammengefaßten gehäuselosen filmmontierten integrierten Bausteinen (Mikropacks) nach einem der vorhergehenden Ansprüche, **dadurch gekennzeichnet,** daß mindestens zwei streifenförmige Stücke (21,22) des Trägerfilms über alle Außenanschlüsse (5) jeweils einer Seite des Bausteins (3) nach dem Freiätzen stehen bleiben.

10. Einrichtung zum Kühlen von zu Flachbaugruppen zusammengefaßten gehäuselosen filmmontierten integrierten Bausteinen (Mikropacks) nach einem der vorhergehenden Ansprüche, **dadurch gekennzeichnet,** daß die Leiterplatte (7) in Mikroverdrahtungstechnik aufgebaut ist.

11. Einrichtung zum Kühlen von zu Flachbaugruppen zusammengefaßten gehäuselosen filmmontierten integrierten Bausteinen (Mikropacks) nach Anspruch 1, **dadurch gekennzeichnet,** daß die elastische Folie wärmeleitend ausgebildet ist.
